# EUROPEAN PATENT APPLICATION

(11) **EP 4 498 407 A1**
(43) Date of publication of application: **29.01.2025**
(21) Application number: 23774504.7
(22) Date of filing: 07.03.2023
(51) Int. Cl.: H01L 21/52, H01L 23/12, H01L 23/14

(54) **LAMINATE MANUFACTURING METHOD**

(30) Priority: 22.03.2022 JP 2022045096
(71) Applicant: NHK Spring Co., Ltd., Yokohama-shi, Kanagawa 236-0004 (JP); LPS Tech Co.,Ltd, Kumagaya-shi, Saitama 360-0042 (JP)
(72) Inventor: SAITO, Shinji, Yokohama-shi, Kanagawa 236-0004 (JP); MIZUNO, Katsumi, Yokohama-shi, Kanagawa 236-0004 (JP); SUZUKI, Kohei, Yokohama-shi, Kanagawa 236-0004 (JP); WATANABE, Toshinori, Yokohama-shi, Kanagawa 236-0004 (JP); YANO, Shinya, Yokohama-shi, Kanagawa 236-0004 (JP); FUJINO, Nijianzu, Yokohama-shi, Kanagawa 236-0004 (JP); Xiaoguang Liang, Kumagaya-shi, Saitama 360-0042 (JP)
(74) Representative: TBK
(86) International application number: PCT/JP2023/008485
(87) International publication number: WO 2023/181905

(57) **Abstract**

Provided is a method for manufacturing a laminated body that is capable of maintaining stable bonding between the electronic component and the circuit pattern even when the employed electronic component generates a large amount of heat, and suppressing defects caused in the insulating layer. A method for manufacturing a laminated body (1) in which a base substrate (2), an insulating layer (3), a circuit pattern (4), and an electronic component (5) are laminated in this order, the method including: a step of providing the insulating layer (3) on a front surface side of the base substrate (2); a step of providing the electronic component (5) on a front surface side of the circuit pattern (4); and a step of laminating the insulating layer (3) provided on the base substrate (2) and the circuit pattern (4) provided with the electronic component (5) with each other.

## Description

### Technical Field

The present invention relates to a method for manufacturing a laminated body.

### Background Art

It has been known that a laminated body is made by laminating a circuit pattern on the front surface side of an insulating layer, and mounting an electronic component on the circuit pattern. To radiate heat generated from the electronic component, the laminated body has a base substrate laminated on the back surface side of the insulating layer, the base substrate including a heat sink or a heat radiation plate. Conventionally, solder has been widely used as a bonding material to mount the electronic component on the circuit pattern.

In recent years, electronic devices have been advanced in performance and miniaturization. Accordingly, electronic components generate an increasing amount of heat. For example, a semiconductor chip (for example, a SiC power device) using SiC (silicon carbide) can conduct a large current, and thus may have a high temperature (for example, 300°C or higher) during operation. On the other hand, solder has a relatively low melting point. When solder is used as a bonding material for such an electronic component operating at high temperatures, the solder may be remelted during operation of the semiconductor chip, leading problems such as peeling of the semiconductor chip and a short circuit in the circuit pattern.

As a technique for solving such a problem, a method of using a paste containing metal nanoparticles such as Ag nanoparticles and Cu nanoparticles as a bonding material is known (see, for example, Patent Literature 1). In this method, a conductive pattern (circuit pattern) is provided on an insulating substrate (insulating layer). Then, a paste containing metal nanoparticles is provided between the circuit pattern and the electronic component, and the electronic component is heated at a predetermined temperature under pressurization. Thus, the metal nanoparticles are sintered to bond the circuit pattern and the electronic component. According to such a technique of sintering metal nanoparticles, high heat resistance can be obtained as compared with the case of using solder.

### Citation List

### Patent Literature

Patent Literature 1: JP 2008-10703 A

### Summary of Invention

### Technical Problem

When the metal nanoparticles are sintered, the electronic component is pressurized under a high temperature environment and at a high load. That is, the insulating layer is also pressurized under a high temperature environment and at a high load. Therefore, the insulating layer may be cracked or the insulating layer may be peeled. When a ceramic substrate is used as the insulating layer, not only the ceramic substrate may be cracked, but also the ceramic substrate may warp to cause a defective bonding between the electronic component and the circuit pattern or to crack the electronic component. Further, when the ceramic substrate warps, the mounted electronic component becomes defective in parallelism or flatness, which may cause defects in the subsequent processes such as wire bonding.

In view of such conventional problems, an object of the present invention is to provide a method for manufacturing a laminated body that is capable of maintaining stable bonding between the electronic component and the circuit pattern even when the employed electronic component generates a large amount of heat, and suppressing defects caused in the insulating layer.

### Solution to Problem

The present invention is a method for manufacturing a laminated body in which a base substrate, an insulating layer, a circuit pattern, and an electronic component are laminated in this order, the method including: a step of providing the insulating layer on a front surface side of the base substrate;
a step of providing the electronic component on a front surface side of the circuit pattern; and a step of laminating the insulating layer provided on the base substrate and the circuit pattern provided with the electronic component with each other.

In the method for manufacturing a laminated body as described above, preferably, the insulating layer is semi-cured in the step of providing the insulating layer on a front surface side of the base substrate, and the insulating layer is full-cured in the step of laminating the insulating layer provided on the base substrate and the circuit pattern provided with the electronic component with each other.

In the method for manufacturing a laminated body as described above, preferably, the step of providing the insulating layer on a front surface side of the base substrate includes: a step of heating a resin composition applied on a base sheet to form the semi-cured insulating layer on the base sheet; and a step of heating and pressurizing the semi-cured insulating layer disposed on the base substrate, followed by peeling off the base sheet, to transfer the semi-cured insulating layer onto the front surface side of the base substrate, and the step of laminating the insulating layer provided on the base substrate and the circuit pattern provided with the electronic component with each other includes: a step of disposing the circuit pattern provided with the electronic component on the semi-cured insulating layer transferred onto the front surface side of the base substrate, followed by heating and pressurizing, to temporarily bond the circuit pattern to the insulating layer; and a step of heating and pressurizing the insulating layer temporarily bonded to the circuit pattern to full-cure the insulating layer.

In the method for manufacturing a laminated body as described above, preferably, the insulating layer is pressurized at a temperature of 30 to 180°C under a pressure of 1 to 25 MPa in the step of transferring the semi-cured insulating layer onto the front surface side of the base substrate.

In the method for manufacturing a laminated body as described above, preferably, in the step of temporarily bonding the circuit pattern to the insulating layer, the insulating layer and the circuit pattern are pressurized at a temperature of 30 to 180°C under a pressure of 0.1 to 25 MPa to temporarily bond the circuit pattern to the insulating layer, and the insulating layer and the circuit pattern are further pressurized at a temperature of 130 to 200°C under a pressure of 0.1 to 25 MPa to temporarily cure the insulating layer; and in the step of full-curing the insulating layer, the insulating layer is pressurized at a temperature of 150 to 300°C under a pressure of 0 to 25 MPa.

The insulating layer is preferably a cured film of a latent curable resin composition. Examples of the latent curable resin composition include an epoxy resin composition containing an epoxy resin, an aromatic amine compound represented by the following general formula (1), a boron-phosphorus complex represented by the following general formula (2), and a phosphorus compound represented by the following general formula (3).

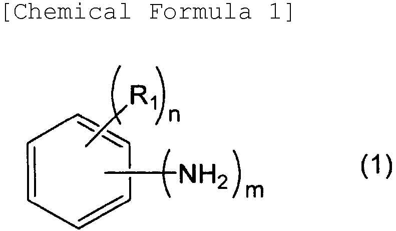

In the general formula (1), R₁ represents an alkyl group, "m" represents an integer of 2 or more, "n" represents an integer of 0 or more, and "m" and "n" satisfy m + n ≤ 6. When "n" is an integer of 2 or more, a plurality of R₁s may be the same as or different from each other.

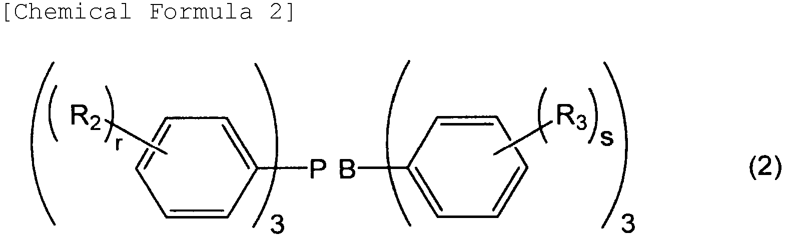

In the general formula (2), R₂ and R₃ each independently represent an alkyl group, "r" represents an integer of 0 or more and 5 or less, and "s" represents an integer of 0 or more and 5 or less. When "r" is an integer of 2 or more, a plurality of R₂s may be the same as or different from each other. When "s" is an integer of 2 or more, a plurality of R₃s may be the same as or different from each other.

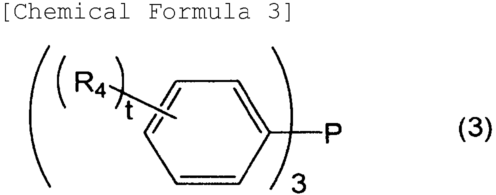

In the general formula (3), R₄ represents an alkyl group or an alkoxy group, and "t" represents an integer of 0 or more and 5 or less. When "t" is an integer of 2 or more, a plurality of R₄s may be the same as or different from each other.

### Advantageous Effects of Invention

The present invention is capable of maintaining stable bonding between the electronic component and the circuit pattern even when the employed electronic component generates a large amount of heat, and suppressing defects caused in the insulating layer.

### Brief Description of Drawings

Fig. 1 is a view illustrating a laminated body manufactured by a method for manufacturing a laminated body of an embodiment of the present invention.
Fig. 2 is a view illustrating the first step to the second step of a method for manufacturing a laminated body of an embodiment of the present invention.
Fig. 3 is a view illustrating the third step of a method for manufacturing a laminated body of an embodiment of the present invention.
Fig. 4 is a view illustrating the fourth step to the sixth step of a method for manufacturing a laminated body of an embodiment of the present invention.

### Description of Embodiments

Hereinafter, the method for manufacturing a laminated body of an embodiment of the present invention will be described with reference to the attached drawings. Note that the views illustrated in the attached drawings are schematic, and the thickness and width of each portion, the ratio between the portions, and the like may be different from those actually implemented.

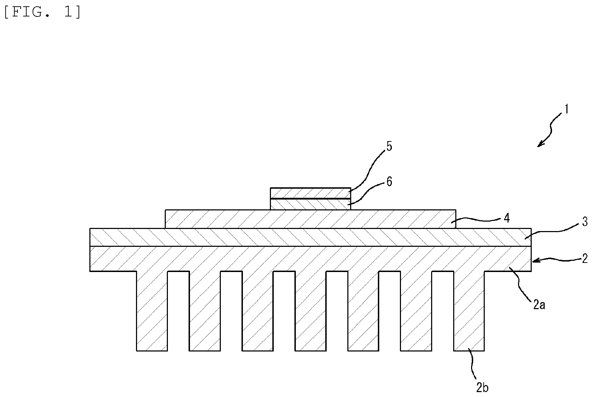

Fig. 1 is a view illustrating a laminated body 1 manufactured by the manufacturing method of the present embodiment. The laminated body 1 includes a heat sink 2, an insulating layer 3, a circuit pattern 4, an electronic component 5, and a bonding layer 6.

The heat sink 2 includes a base portion 2a having a plate shape and a fin 2b having a comb-shape and protruding from the base portion 2a, and has a function in which heat transferred to the base portion 2a is radiated from the fin 2b to the outside. The heat sink 2 is preferably formed of a material having high thermal conductivity, and is preferably formed of, for example, a metal such as copper, aluminum, or iron (may be a simple metal or an alloy).

The heat sink 2 corresponds to the "base substrate" in the present specification. The shape of the "base substrate" is not limited to the shape including the fin 2b illustrated in the drawing, and may be, for example, a plate shape formed only of the base portion 2a. The "base substrate" is not limited to a substrate formed of a single member, and may be a substrate formed of a combination of a plurality of members. The "base substrate" may include a configuration that further improves the effect of radiating heat to the outside, and may be, for example, a metal plate embedded with a vapor chamber or a heat pipe.

The insulating layer 3 is formed of an insulating material, and is provided to cover the surface of the base portion 2a of the heat sink 2. The insulating layer 3 may cover the entire surface of the base portion 2a or may cover a part of the surface.

Examples of the material of the insulating layer 3 include a resin composition containing a thermosetting resin. Examples of the thermosetting resin include an epoxy resin, a phenol resin, a melamine resin, a urea resin, an unsaturated polyester resin, an alkyd resin, and a cyanate resin. The thermosetting resin may be used in one kind alone, or two or more kinds thereof may be used in combination.

As the epoxy resin, regardless of the molecular weight and molecular structure thereof, it is possible to use any of a monomer, an oligomer, and a polymer having two or more epoxy groups in one molecule. Specific examples of such an epoxy resin include: bisphenol type epoxy resins such as a bisphenol A type epoxy resin, a bisphenol F type epoxy resin, a bisphenol E type epoxy resin, a bisphenol S type epoxy resin, a hydrogenated bisphenol A type epoxy resin, a bisphenol M type epoxy resin (4,4'-(1,3-phenylenediisopridiene) bisphenol type epoxy resin), a bisphenol P type epoxy resin (4,4'-(1,4-phenylenediisopridiene) bisphenol type epoxy resin), and a bisphenol Z type epoxy resin (4,4'-cyclohexydiene bisphenol type epoxy resin); novolac type epoxy resins such as a phenol novolac type epoxy resin, a brominated phenol novolac type epoxy resin, a cresol novolac type epoxy resin, a tetraphenol group ethane type novolac type epoxy resin, and a novolac type epoxy resin having a condensed ring aromatic hydrocarbon structure; biphenyl type epoxy resins; aralkyl type epoxy resins such as a xylylene type epoxy resin and a biphenyl aralkyl type epoxy resin; epoxy resins having a naphthalene skeleton, such as a naphthylene ether type epoxy resin, a naphthol type epoxy resin, a naphthalene type epoxy resin, a naphthalene diol type epoxy resin, a bifunctional to tetrafunctional epoxy type naphthalene resin, a binaphthyl type epoxy resin, or a naphthalene aralkyl type epoxy resin; anthracene type epoxy resins; phenoxy type epoxy resins; dicyclopentadiene type epoxy resins; norbornene type epoxy resins; adamantane type epoxy resins; heterocyclic epoxy resins such as a fluorene type epoxy resin, a phosphorus-containing epoxy resin, an alicyclic epoxy resin, an aliphatic chain epoxy resin, a bisphenol A novolac type epoxy resin, a bixylenol type epoxy resin, a triphenol methane type epoxy resin, a trihydroxyphenylmethane type epoxy resin, a tetraphenylolethane type epoxy resin, and triglycidyl isocyanurate; glycidyl amines such as N,N,N',N'-tetraglycidylmetaxylenediamine, N,N,N',N'-tetraglycidylbisaminomethylcyclohexane, and N,N-diglycidylaniline; copolymers of glycidyl (meth) acrylate and a compound having an ethylenically unsaturated double bond; epoxy resins having a butadiene structure; diglycidyl etherified bisphenols; diglycidyl etherified naphthalenediols; and glycidyl etherified phenols. The resin composition of the present embodiment may contain one or two or more epoxy resins selected therefrom.

For example, other than the thermosetting resin, a curing agent is contained in the resin composition. The curing agent is selected according to the type of thermosetting resin, and is not particularly limited as long as it reacts with the thermosetting resin. When an epoxy resin is used, examples of the curing agent include an amine-based curing agent, an imidazole-based curing agent, and a phenol-based curing agent.

For example, the curing agent contains an aromatic amine compound represented by the following general formula (1).

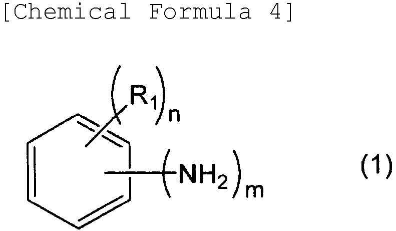

In the general formula (1), R₁ represents an alkyl group, "m" represents an integer of 2 or more, "n" represents an integer of 0 or more, and "m" and "n" satisfy m + n ≤ 6. When "n" is an integer of 2 or more, a plurality of R₁s may be the same as or different from each other.

"m" represents the number of substituting amino groups on the benzene ring, and is 2 or more and 6 or less, may be 2 or more and 5 or less, may be 2 or 3, or may be 2. When "m" is 2, the arrangement of two amino groups on the benzene ring is preferably a meta position or an ortho position for the other amino group.

R₁ is an arbitrary substituent on the benzene ring. The alkyl group represented by R₁ may have 1 to 4 carbon atoms, or may have 1 or 2 carbon atoms. Specific examples of the alkyl group include a methyl group, an ethyl group, a propyl group, and a butyl group. "n" represents the number of substituting R₁s on the benzene ring, and is 0 or more and 4 or less, may be 0 or more and 3 or less, or may be 1 or more and 3 or less.

The aromatic amine compound represented by the general formula (1), having small steric hindrance, is excellent in curability-improving effect and can exhibit sufficient performance even when cured in a short time.

The resin composition may contain a filler (inorganic filler). The filler preferably has excellent insulation properties and high thermal conductivity. Examples thereof include aluminum oxide, silica, aluminum nitride, boron nitride, silicon nitride, and magnesium oxide.

The resin composition may contain a curing accelerator, a stabilizer, an ion scavenger, a solvent, and the like. The resin composition may contain a softness-imparting agent.

For example, the curing accelerator contains a boron-phosphorus complex represented by the following general formula (2).

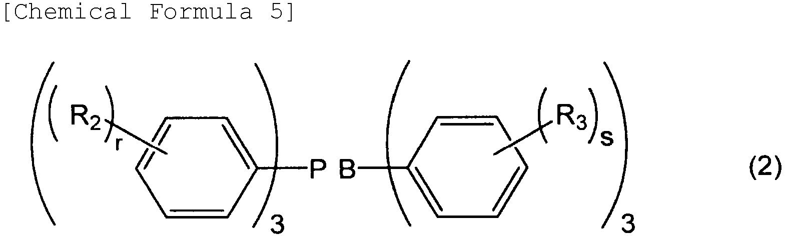

In the general formula (2), R₂ and R₃ each independently represent an alkyl group, "r" represents an integer of 0 or more and 5 or less, and "s" represents an integer of 0 or more and 5 or less. When "r" is an integer of 2 or more, a plurality of R₂s may be the same as or different from each other. When "s" is an integer of 2 or more, a plurality of R₃s may be the same as or different from each other.

R₂ and R₃ are arbitrary substituents on the benzene ring. Specific examples of the alkyl group represented by R₂ and R₃ include a methyl group and an ethyl group.

"r" represents the number of substituting R₂ on the P atom-substituted benzene ring, and is 0 or more and 5 or less, may be 0 or more and 3 or less, may be 0 or more and 2 or less, and may be 0 or 1. When "r" is 1, the alkyl group represented by R₂ may be arranged at any of an ortho position, a meta position, and a para position for the P atom.

"s" represents the number of substituting R₃ on the B atom-substituted benzene ring, and is 0 or more and 5 or less, may be 0 or more and 3 or less, may be 0 or more and 2 or less, and may be 0.

When the boron-phosphorus complex represented by the general formula (2) is contained as the curing accelerator, a phosphorus compound represented by the following general formula (3) is preferably contained as the stabilizer.

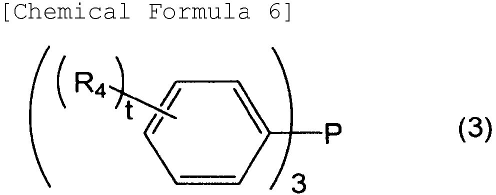

In the general formula (3), R₄ represents an alkyl group or an alkoxy group, and "t" represents an integer of 0 or more and 5 or less. When "t" is an integer of 2 or more, a plurality of R₄s may be the same as or different from each other.

R₄ is an arbitrary substituent on the benzene ring. Specific examples of the alkyl group represented by R₄ include a methyl group, an ethyl group, and a propyl group. Specific examples of the alkoxy group represented by R₄ include a methoxy group and a butoxy group.

By the way, as described later, the insulating layer 3 is preferably a cured film formed from a latent curable resin composition having latent curing characteristics, which is difficult to cure at around normal temperature, but can transfer or temporarily bond to the other object when heated to a predetermined temperature. For example, when the insulating layer 3 is a cured film of an epoxy resin composition containing an epoxy resin, an aromatic amine compound represented by the general formula (1), a boron-phosphorus complex represented by the general formula (2), and a phosphorus compound represented by the general formula (3), the latent curing characteristics can be exhibited. The latent curable resin composition is preferably a system that can be stored for a long period of time in a state in which the epoxy resin and the curing agent are mixed, and starts a curing reaction when a stimulus such as heat, light, pressure, or moisture is applied. The rise of the exothermic peak (curing start temperature) associated with the curing reaction is preferably 40°C or higher in terms of differential scanning calorimetry. In addition, as the curing agent for the epoxy resin or an additive to the epoxy resin and the curing agent, dicyandiamide, a dihydrazide compound, various amine adduct-based latent curing agents, 2-phenyl-4-methyl-5-hydroxymethylimidazole, 3-(3,4-dichlorophenyl)-1,1-dimethylurea, an onium salt (sulfonium salt, phosphonium salt), a boron halide/amine complex, a vinyl ether block carboxylic acid, an active ester of a polyvalent carboxylic acid, a ketimine compound, a silanol group-containing polymer, or the like may be used.

"t" represents the number of substituting R₄ on the benzene ring, and is 0 or more and 5 or less, may be 0 or more and 4 or less, may be 0 or more and 2 or less, or may be 0.

The circuit pattern 4 is obtained by forming a predetermined pattern using a conductive material. Examples of such a material include a metal foil of copper or aluminum. The thickness of the metal foil is, for example, about 0.01 to 2.0 mm. Examples of the method for forming a predetermined pattern include: a method of forming a mask pattern on the metal foil and removing the exposed portion of the metal foil by etching; and a method of punching the metal foil using a mold.

The electronic component 5 is, for example, a semiconductor chip. The electronic component 5 used in the present embodiment is not limited. However, the method for manufacturing a laminated body of the present embodiment is particularly suitable when a semiconductor chip (for example, a SiC power device) having a high temperature during operation is used.

The bonding layer 6 has functions of electrically connecting the circuit pattern 4 and the electronic component 5 and fixing the electronic component 5 to the circuit pattern 4. The bonding layer 6 is appropriately selected in consideration of the material forming the circuit pattern 4, the amount of heat generated from the electronic component 5, the load on the environment, and the like. Examples of the bonding layer 6 include: a solder layer (for example, a Sn-based solder layer or a Zn-Al-based solder layer) obtained by melting solder; and a sintered metal layer obtained by sintering metal nanoparticles (Ag nanoparticles, Cu nanoparticles, etc.).

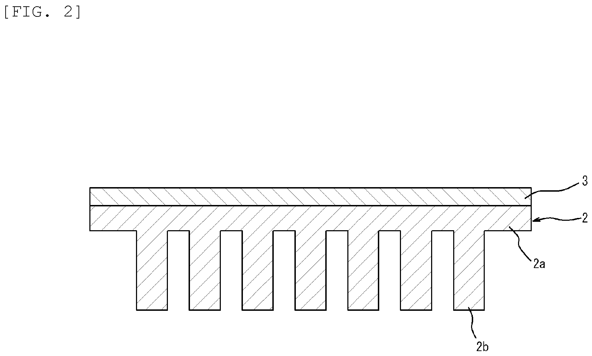

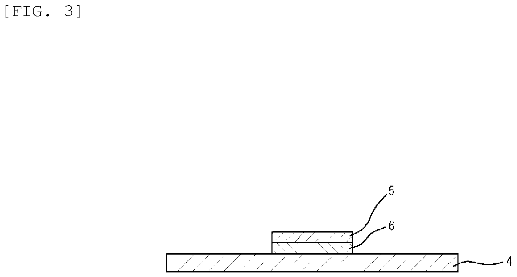

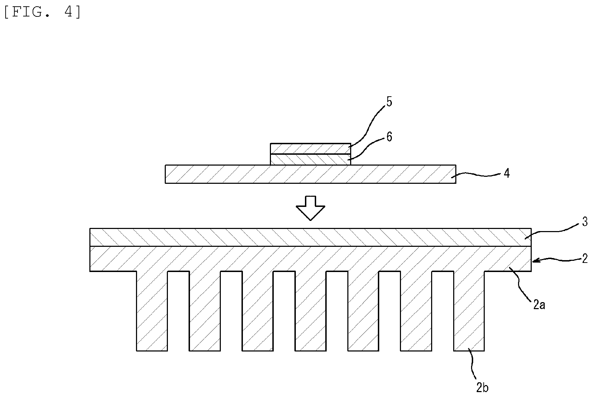

Next, the method for manufacturing the laminated body 1 will be described with reference to Figs. 2 to 4. Fig. 2 is a view illustrating the first step and the second step of the method for manufacturing the laminated body 1, Fig. 3 is a view illustrating the third step, and Fig. 4 is a view illustrating the fourth step, the fifth step, and the sixth step. The first step corresponds to the "step of heating a resin composition applied on a base sheet to form the semi-cured insulating layer on the base sheet" in the present specification, and the second step corresponds to the "step of heating and pressurizing the semi-cured insulating layer disposed on the base substrate, followed by peeling off the base sheet, to transfer the semi-cured insulating layer onto the front surface side of the base substrate" in the present specification. The third step corresponds to the "step of providing the electronic component on a front surface side of the circuit pattern" in the present specification. The fourth step and the fifth step correspond to the "step of disposing the circuit pattern provided with the electronic component on the semi-cured insulating layer transferred onto the front surface side of the base substrate, followed by heating and pressurizing, to temporarily bond the circuit pattern to the insulating layer" in the present specification, and the sixth step corresponds to the "step of heating and pressurizing the insulating layer temporarily bonded to the circuit pattern to full-cure the insulating layer". In the following description, the first step, the second step, and the rest will be described in this order, but the present invention is not limited to the case where the steps are performed in this order. The order may be changed within a range in which the steps are completed, or the steps may be performed simultaneously. The temperature, pressure, and time conditions described below are exemplified for the case when an epoxy resin (for example, bisphenol A type epoxy resin) is used as the resin composition.

First, in the first step, a base sheet formed of, for example, PET is prepared, the above-described resin composition is applied to the base sheet, and the resin composition is further heated together with the base sheet to form the semi-cured insulating layer 3 on the base sheet. In the first step, the resin composition is heated together with the base sheet at a temperature of 50 to 200°C for a heating time of 10 to 200 minutes. In the first step, the heating conditions are more preferably at a temperature of 50 to 180°C and for a heating time of 10 to 180 minutes, and further preferably at a temperature of 50 to 160°C and for a heating time of 10 to 160 minutes.

In the second step, the semi-cured insulating layer 3 formed on the base sheet is disposed on the front surface side of a heat sink 2 shown in Fig. 2, and heated and pressurized. After that, the base sheet is peeled off to transfer the semi-cured insulating layer 3 onto the front surface side of the heat sink 2. In the second step, the heating and pressurizing conditions are at a temperature of 30 to 180°C, under a pressure of 1 to 25 MPa, and for a pressurizing time of 10 to 300 seconds. In the second step, the heating and pressurizing conditions are more preferably at a temperature of 30 to 160°C, under a pressure of 3 to 25 MPa, and for a pressurizing time of 10 to 240 seconds, and further preferably at a temperature of 30 to 140°C, under a pressure of 5 to 25 MPa, and for a pressurizing time of 10 to 180 seconds.

As an alternative method for the first step and the second step, a method of applying the above-described resin composition on the surface of the base portion 2a of the heat sink 2 using a roll coating method, a bar coating method, a screen printing method, or the like, followed by heating and pressurizing, to provide the semi-cured insulating layer 3 on the surface of the base portion 2a may be employed.

In order to semi-curing the insulating layer 3, for example, when the resin composition is applied on the surface of the base portion 2a by a roll coating method or the like, the resin composition is applied on the surface of the base portion 2a, and the resin composition is heated. When an epoxy resin (for example, a bisphenol A type epoxy resin) is used as the thermosetting resin in this method, for example, the resin composition is applied, then heated at a temperature of 80°C for 60 minutes, and then heated at a temperature of 90°C and pressurized under a pressure of 23 MPa at the same time.

In the third step illustrated in Fig. 3, the electronic component 5 is mounted on the front surface side of the circuit pattern 4. In order to mount the electronic component 5 on the circuit pattern 4, for example, a solder paste is applied to a predetermined position in the circuit pattern 4, the electronic component 5 is disposed on the solder paste, and the solder is melted by heating at a predetermined temperature, thereby both are bonded. Instead of the solder paste, a paste containing metal nanoparticles may be used. In this case, the metal nanoparticle-containing paste is applied to the circuit pattern 4, the electronic component 5 is disposed thereon, and the electronic component 5 is heated at a predetermined temperature under pressurization to sinter the metal nanoparticles. Thereby, the circuit pattern 4 and the electronic component 5 are bonded. When the solder paste or the metal nanoparticle-containing paste is applied, various methods including, for example, a roll coating method, a bar coating method, or a screen printing method can be used.

After the first to third steps are performed, the fourth to sixth steps shown in Fig. 4 are performed. In the fourth step, the semi-cured insulating layer 3 provided on the heat sink 2 and the circuit pattern 4 on which the electronic component 5 is mounted are temporarily bonded. In the fifth step, the insulating layer 3 to which the circuit pattern 4 is temporarily bonded is temporarily cured, and thereby the circuit pattern 4 is temporarily bonded to the insulating layer 3. In the sixth step, which is performed thereafter, the temporarily cured insulating layer 3 is full-cured. When the fourth to sixth steps are performed, devices capable of heating and pressurizing at the same time are used, including a hot press machine or an autoclave.

In the fourth step described above, the electronic component 5 and/or the circuit pattern 4 is pressurized at a pressure of 0.1 to 25 MPa while being heated at a temperature of 30 to 180°C. The pressurizing time is 10 to 300 seconds. In the fourth step, the conditions of temperature and pressure are more preferably heating at a temperature of 30 to 160°C while pressurizing under a pressure of 0.1 to 20 MPa, and for a pressurizing time of 10 to 240 seconds, and further preferably heating at a temperature of 30 to 140°C while pressurizing under a pressure of 0.1 to 15 MPa, and for a pressurizing time of 10 to 180 seconds.

In the fifth step, the electronic component 5 and/or the circuit pattern 4 is pressurized at a pressure of 0.1 to 25 MPa while being heated at a temperature of 130 to 200°C. The pressurizing time is 1 to 30 minutes. In the fifth step, the conditions of temperature and pressure are more preferably heating at a temperature of 130 to 200°C while pressurizing under a pressure of 0.1 to 20 MPa, and for a pressurizing time of 1 to 30 minutes, and further preferably heating at a temperature of 130 to 200°C while pressurizing under a pressure of 0.1 to 15 MPa, and for a pressurizing time of 1 to 30 minutes.

In the sixth step, the electronic component 5 and/or the circuit pattern 4 is pressurized at a pressure of 0 to 25 MPa while being heated at a temperature of 150 to 300°C. The pressurizing time is 30 to 180 minutes. In the sixth step, the conditions of temperature and pressure are more preferably heating at a temperature of 150 to 300°C while pressurizing under a pressure of 0 to 20 MPa, and for a pressurizing time of 30 to 180 minutes, and further preferably heating at a temperature of 150 to 300°C while pressurizing under a pressure of 0 to 15 MPa, and for a pressurizing time of 30 to 180 minutes.

In the above-described pressure range, the pressure of 0 MPa in pressurization means a non-pressurized state. The circuit pattern 4 may be temporarily bonded to the insulating layer 3 in one step without separating the step into two steps: the fourth step and the fifth step, or in three or more steps. The insulating layer 3 may be full-cured not only in one step as described above, but also in two or more steps.

In the method for manufacturing the laminated body 1 described above, even when a metal nanoparticle-containing paste is used to bond the circuit pattern 4 and the electronic component 5, the insulating layer 3 is not laminated on the circuit pattern 4 or the electronic component 5 in the step of sintering the metal nanoparticles. That is, the insulating layer 3 is not affected by the high-load pressurization under a high-temperature environment necessary for sintering the metal nanoparticles. Therefore, it is possible to suppress a case where the insulating layer 3 has defects such as cracking, which may occur in a conventional method. When the circuit pattern 4 on which the electronic component 5 is mounted is laminated on the semi-cured insulating layer 3, the semi-cured insulating layer 3 is not excessively crushed and can maintain a predetermined thickness when the electronic component 5 is pressurized. Therefore, the insulating layer 3 can stably secure an insulating property.

Examples of the present invention will be described below. Note that the present invention is not limited to Examples.

### <Examples>

A resin composition was prepared as the material of the insulating layer 3. The resin composition used had a formulation of: 100 parts by mass of a bisphenol A type epoxy resin (trade name: EXA-850CRP; manufactured by DIC Corporation); 28 parts by mass of a curing agent ("DETDA-80"; manufactured by Lonza Ltd); 0.9 parts by mass of a curing accelerator ("TTP-S"; manufactured by HOKKO CHEMICAL INDUSTRY CO., LTD.); 0.3 parts by mass of a stabilizer ("TPP"; manufactured by HOKKO CHEMICAL INDUSTRY CO., LTD.); 24 parts by mass of a softness-imparting agent; 3 parts by mass of an ion scavenger; 210 parts by mass of aluminum oxide (trade name: AS40; manufactured by Showa Denko K.K.) as a filler; 339 parts by mass of a boron nitride (BN) aggregate (trade name: HP40MF100; manufactured by Mizushima Ferroalloy Co., Ltd.); 60 parts by mass of a boron nitride (BN) fine powder (trade name: NX1; manufactured by Momentive); and 248 parts by mass of ethyl 3-ethoxypropionate (EEP) as a solvent.

The resin composition was applied on the base sheet and heated to form the semi-cured insulating layer 3 on the base sheet.

Then, in the direction in which the surface of the heat sink 2 and the semi-cured insulating layer 3 were in contact with each other, the insulating layer 3 as well as the base sheet was disposed on the heat sink 2, and pressurized in a vacuum press machine at a temperature of 90°C under a pressure of 23 MPa for 30 seconds. Thereafter, the base sheet was peeled off to transfer the semi-cured insulating layer 3 onto the heat sink 2.

The electronic component 5 was disposed on the circuit pattern 4 coated with a metal nanoparticle-containing paste. Then, the electronic component 5 was mounted on the circuit pattern 4 while being heated at a predetermined temperature under pressurization.

Thereafter, the circuit pattern 4 mounted with the electronic component 5 was disposed at a predetermined position of the semi-cured insulating layer 3. Then, in a vacuum press machine, the circuit pattern 4 was temporarily bonded to the insulating layer 3 by pressurization at a temperature of 75°C under a pressure of 4 MPa for 40 seconds.

Next, the vacuum press machine was set to the vacuum-exhausted state (atmosphere open state), the insulating layer 3 was temporarily cured by pressurization at a temperature of 180°C under a pressure of 4 MPa for 780 seconds.

Thereafter, the insulating layer 3 was left standing at a temperature of 185°C under a pressure of 0 MPa (non-pressurized state) for 60 minutes to be full-cured.

When the laminated body 1 manufactured by the above method was checked, the insulating layer 3 had no crack or peeling even under conditions where the electronic component 5 was operating a high temperature. In addition, the electronic component 5 has normal parallelism and flatness.

Although an embodiment of the present invention has been described above, the present invention is not limited to the specific embodiment, and various modifications and changes can be made within the scope of the gist of the present invention described in the claims unless otherwise limited in the above description. In addition, the effects of the above embodiment are merely examples of the effects caused by the present invention, and do not mean that the effects of the present invention are limited to the above effects.

For example, the layer configuration in the laminated body 1 is not limited to the above embodiment, and another layer may be interposed between the above layers. As an example of changing the layer configuration, an adhesive sheet is interposed between the heat sink 2 and the insulating layer 3. A liquid adhesive may be applied to the surface of the insulating layer 3. When voids are formed in the surface of the insulating layer 3, the liquid adhesive is applied so that the voids are filled with the liquid adhesive. That is, in the adhesion between the insulating layer 3 and the other object, the adhesion function of the portion where voids are formed can be compensated by the liquid adhesive. The insulating layer 3 has an insulating property, and is not limited to one formed from a resin composition. Examples of the insulating layer 3 other than a resin composition include a ceramic substrate.

### Reference Signs List

- 1: Laminated body
- 2: Heat sink (Base substrate)
- 3: Insulating layer
- 4: Circuit pattern
- 5: Electronic component

## Claims

1. A method for manufacturing a laminated body in which a base substrate, an insulating layer, a circuit pattern, and an electronic component are laminated in this order, the method comprising:
a step of providing the insulating layer on a front surface side of the base substrate;
a step of providing the electronic component on a front surface side of the circuit pattern; and
a step of laminating the insulating layer provided on the base substrate and the circuit pattern provided with the electronic component with each other.

2. The method for manufacturing a laminated body according to claim 1, wherein
the insulating layer is semi-cured in the step of providing the insulating layer on a front surface side of the base substrate, and
the insulating layer is full-cured in the step of laminating the insulating layer provided on the base substrate and the circuit pattern provided with the electronic component with each other.

3. The method for manufacturing a laminated body according to claim 2, wherein
the step of providing the insulating layer on a front surface side of the base substrate includes:
a step of heating a resin composition applied on a base sheet to form the semi-cured insulating layer on the base sheet; and
a step of heating and pressurizing the semi-cured insulating layer disposed on the base substrate, followed by peeling off the base sheet, to transfer the semi-cured insulating layer onto the front surface side of the base substrate, and
the step of laminating the insulating layer provided on the base substrate and the circuit pattern provided with the electronic component with each other includes:
a step of disposing the circuit pattern provided with the electronic component on the semi-cured insulating layer transferred onto the front surface side of the base substrate, followed by heating and pressurizing, to temporarily bond the circuit pattern to the insulating layer; and
a step of heating and pressurizing the insulating layer temporarily bonded to the circuit pattern to full-cure the insulating layer.

4. The method for manufacturing a laminated body according to claim 3, wherein the insulating layer is pressurized at a temperature of 30 to 180°C under a pressure of 1 to 25 MPa in the step of transferring the semi-cured insulating layer onto the front surface side of the base substrate.

5. The method for manufacturing a laminated body according to claim 3 or 4, wherein
in the step of temporarily bonding the circuit pattern to the insulating layer, the insulating layer and the circuit pattern are pressurized at a temperature of 30 to 180°C under a pressure of 0.1 to 25 MPa to temporarily bond the circuit pattern to the insulating layer, and the insulating layer and the circuit pattern are further pressurized at a temperature of 130 to 200°C under a pressure of 0.1 to 25 MPa to temporarily cure the insulating layer; and
in the step of full-curing the insulating layer, the insulating layer is pressurized at a temperature of 150 to 300°C under a pressure of 0 to 25 MPa**.**

6. The method for manufacturing a laminated body according to any one of claims 1 to 5, wherein the insulating layer is a cured film of a latent curable resin composition.
